# EUROPEAN PATENT APPLICATION

(11) **EP 1 376 198 A1**
(43) Date of publication of application: **02.01.2004**
(21) Application number: 02705508.6
(22) Date of filing: 26.03.2002
(51) Int. Cl.: G02B 27/00

(54) **SEMICONDUCTOR LASER DEVICE**

(30) Priority: 26.03.2001 JP 2001088437
(71) Applicant: HAMAMATSU PHOTONICS K. K., Hamamatsu-shi, Shizuoka 435-8558 (JP)
(72) Inventor: KUSUYAMA, Yutaka, c/o Hamamatsu Photonics K.K., Hamamatsu-shi, Shizuoka 435-8558 (JP)
(74) Representative: Frost, Alex John
(86) International application number: PCT/JP2002/002932
(87) International publication number: WO 2002/077698

(57) **Abstract**

A semiconductor laser device 1 comprises a stack-type semiconductor laser element 2 which is formed by piling up along a Y axis direction orthogonal to an X axis direction a plurality of stacks of array-type semiconductor laser elements 3 including a plurality of light emitting parts that are aligned in the X axis direction, where the X axial pitch P₁ of the light emitting parts 21 and the Y axial pitch P₂ of the light emitting parts 21 satisfy a relational expression of P₁ < P₂, and a second optical lens 5 which outputs beams that have been outputted from the light emitting parts 21 after rotating them by 90 degrees.

## Description

### TECHNICAL FIELD

This invention relates to a semiconductor laser device comprising a semiconductor laser element. Specifically, the invention relates to a semiconductor laser device comprising a stack-type semiconductor laser element in which a plurality of stacks of array-type semiconductor laser elements including a plurality of light emitting parts being aligned are formed.

### BACKGROUND ART

A stack-type semiconductor laser element in which a plurality of stacks of array-type semiconductor laser elements including a plurality of light emitting parts being aligned are formed has conventionally existed. The plurality of stacks increases the number of light emitting parts, and this is effective since it realizes a high output in a case where a semiconductor laser device is prepared by providing an optical lens system including a collimating lens and a condenser lens, etc., at a predetermined position of such a semiconductor laser element, and is applied to a laser machining device.

However, in such a semiconductor laser device, since the light emitting parts are arranged in close formation, beams (divergent beams) emitted from the respective light emitting parts easily overlap each other. Overlapping makes it impossible to individually acquire the beams emitted from the respective light emitting parts, and makes it difficult to realize accurate condensation by the condenser lens in the abovementioned case where the device is applied to a laser machining device . Installation of optical lenses is necessary so as not to cause such overlapping of the beams, however, when the optical lenses are installed for a stack-type semiconductor element, it is necessary not only to prevent overlapping of beams in the alignment direction of the light emitting parts, but also to prevent overlapping of beams in the stacking direction, and this greatly restricts the arrangement positions of the optical lenses and results in a burden on design.

Therefore, an object of the invention is to provide a semiconductor laser device in which the constraint on arrangement of optical lenses which act on beams emitted from the respective light emitting parts is eased.

Another object of the invention is to provide a semiconductor laser device in which the position of overlapping of beams emitted from the stack-type semiconductor laser element can be moved ahead.

### DISCLOSORE OF THE INVENTION

In order to achieve the abovementioned objects, a semiconductor laser device of the invention comprises a stack-type semiconductor laser element formed by piling up along a Y axis direction crossing an X axis direction a plurality of stacks of array-type semiconductor laser elements including a plurality of light emitting parts aligned along the X axis direction, where the optical axes of beams emitted from the plurality of light emitting parts are orthogonal to the X axis direction and the Y axis direction, and the X axial pitch P₁ and the Y axial pitch P₂ of the light emitting parts satisfy a relational expression of P₁ < P₂, a first optical lens which acts on the beams emitted from the respective light emitting parts of the stack-type semiconductor laser element in the Y axis direction, and a second optical lens which outputs the beams that have been outputted from the first optical lens after rotating them around the optical axes.

According to this semiconductor laser device, as for the light emitting parts of the stack-type semiconductor laser element, since the Y axial pitch P₂ is designed so as to be larger than the X axial pitch P₁, by rotating the beams emitted from the respective light emittingparts around the optical axes by the second optical lens (optical path converter), the point at which the beams emitted from the light emitting parts start overlapping each other in the X axis direction (Y axis direction after being rotated) can be moved ahead.

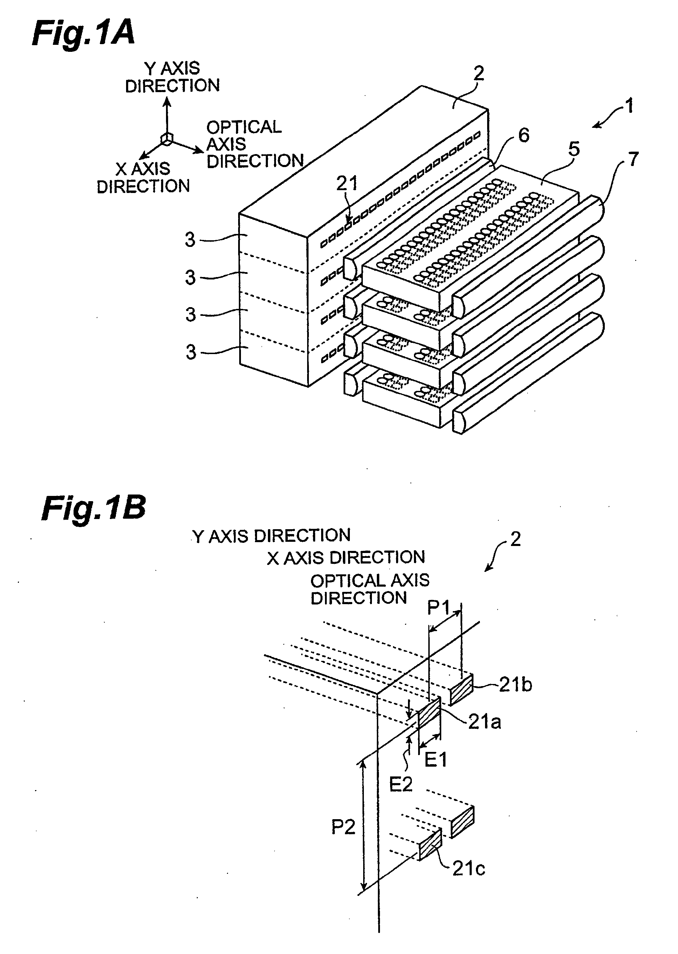

"Acts on beams means that incident divergent beams are outputted after being collimated or condensed. The "X axial pitch" indicates, in optional two light emitting parts adjacent to each other in the X axis direction, an X axial component distance from the middle point in the X axis direction of one light emitting part to the middle point in the X axis direction of another light emitting part. The "Y axial pitch" indicates, in optional two light emitting parts adjacent to each other in the Y axis direction, an Y axial component distance from the middle point in the Y axis direction of one light emitting part to the middle point in the Y axis direction of another light emitting part (see Fig. 1B) .

It is desirable that the second optical lens outputs the beams emitted from the light emitting parts of the stack-type semiconductor laser element after rotating them by 90 degrees around the optical axes.

It is desirable that this first optical lens is disposed before overlapping of the beams emitted from the light emitting parts of the stack-type semiconductor laser element in the Y axis direction.

Furthermore, it is more desirable that this first optical lens is disposed at a position at which the Y axial component length of the beams resulting from its action on the beams emitted from the light emitting parts of the stack-type semiconductor laser element becomes shorter than the X axial pitch P₁ of the light emitting parts. Incident beams onto the second optical lens are set so that the Y axial component length becomes shorter than the X axial pitch P₁ by the action of the first optical lens, beams that have been outputted after being rotated by 90 degrees are prevented from overlapping each other in the X axis direction since their X axial component length (Y axial component length before being rotated) also becomes shorter than P₁.

The semiconductor laser device may further comprise a third optical lens which acts on the beams that have been outputted from the second optical lens in the Y axis direction. By providing the third optical lens, a semiconductor laser device which can emit outgoing beams which have received both X axial and Y axial actions is realized.

Heat sinks may be interposed between the array-type semiconductor laser elements in the stack-type semiconductor laser element. Thereby, the array-type semiconductor laser elements are made to release heat.

### BRIEF DESCRIPTION OF THE DRAWINGS

Fig. 1A is a general view of a semiconductor laser device relating to an embodiment.
Fig. 1B is a partial enlarged view of a stack-type semiconductor laser element.
Fig. 2A and Fig. 2B are general views of a second optical lens to be used for the semiconductor laser device.
Fig. 3 is a drawing showing actions of first through third optical lenses on beams emitted from respective light emitting parts of the stack-type semiconductor laser element.
Fig. 4A and Fig. 4B are diagrams showing paths of beams emitted from two adjacent light emitting parts.

### BEST MODES FOR CARRYING OUT THE INVENTION

Hereinafter, a semiconductor laser device relating to an embodiment of the invention is described with reference to the accompanying drawings. In the description given below, portions that are identical or equivalent to each other are attached with the same symbol, and overlapping description is omitted.

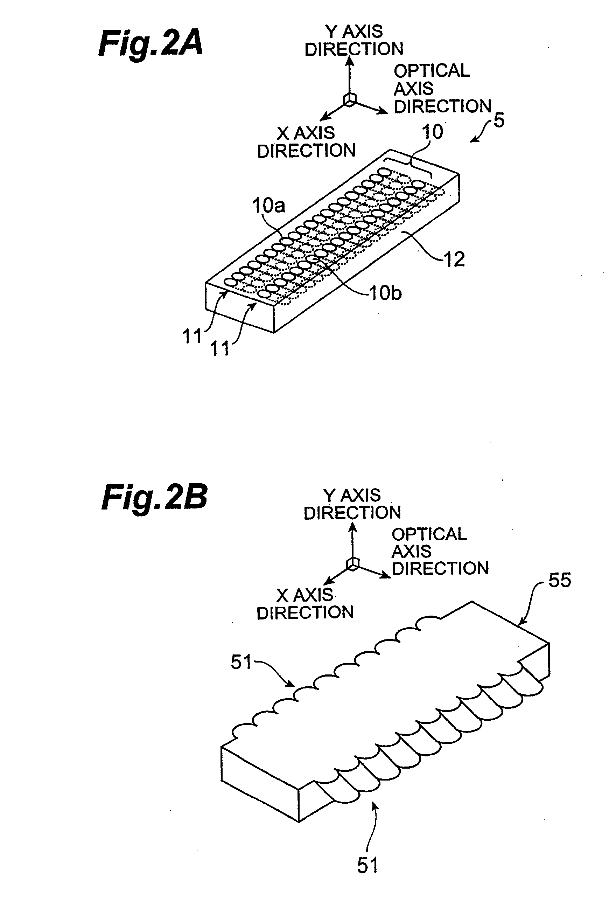

Fig. 1A is a general view of the semiconductor laser device relating to an embodiment, and Fig. 1B is a partial enlarged view of a stack-type semiconductor laser element. Fig. 2A and Fig. 2B are general views of a second optical lens to be used for the semiconductor laser device. The semiconductor laser device 1 comprises a stack-type semiconductor laser element 2 and first through third optical lenses 5, 6, and 7. The stack-type semiconductor laser element 2 is formed by piling up in a Y axis direction orthogonal to an X axis direction a plurality of stacks of array-type semiconductor laser elements 3 including a plurality of light emitting parts (active layer stripes) 21a, 21b... aligned along the X axis direction. In this embodiment, the number of stacks is four.

The light emitting part 21 (this is referred to when the light emitting parts are not individually specified) has a structure having a large width in comparison with its thickness, wherein the width E₂ is 100 to 200µm and the thickness E₁ is 0.1 to 1µm. The light emitting parts 21 are aligned at X axial pitches P₁ and Y axial pitches P₂. P₁ and P₂ satisfy a relational expression of P₁ < P₂. In this embodiment, P₁ = 500µm and P₂ = 1500µm are set. From the definition of P₁, P₁ < E₁ becomes true, and from this, E₁ < P₂ also becomes true. Namely, the Y axial pitch P₂ of the light emitting parts 21 is designed so as to be longer than the X axial length of the light emitting parts 21. The meaning of this relational expression is described later.

The first optical lens 6 outputs beams emitted from the respective light emitting parts 21 of the stack-type semiconductor laser element 2 after collimating them in the Y axis direction. An optical effect part to act on the beams is provided on the light exit surface side. In Fig. 1A, the first optical lens 6 is provided so as to be separated from the light emitting parts 21 of the stack-type semiconductor laser element 2, however, they can be provided close to the light emitting parts. This case has an advantage in that it becomes unnecessary to consider the arrangement position of this lens.

The second optical lens 5 comprises, as shown in Fig. 2B, two lens arrays 11 which are formedbyaligningaplurality of columnar lenses 10 formed from a first translucent material along the X axis direction in a condition where they tilt by 45 degrees with respect to the X axis direction and are orthogonal to the optical axis direction, and an optical member 12 which is formed from a second translucent material having a different refractive index from that of the first translucent material, and has the two lens arrays 11 aligned and embedded parallel to each other. The second optical lens 5 outputs the outgoing beams that have been outputted from the first optical lens 6 after rotating them by 90 degrees around the optical axes. The optical axis direction is orthogonal to the X axis direction and Y axis direction. As the second optical lens, as shown in Fig. 2B, a second optical lens 55 including lens arrays 51 formed in parallel to each other on the light incidence surface and light exit. surface may be used. The lens array 51 is formed by aligning in the X axis direction a plurality of lenses that tilt by 45 degrees from the X axis direction and are orthogonal to the optical axis direction.

The third optical lens 7 outputs the outgoing beams that have been outputted from the second optical lens after collimating them in the Y axis direction. In this embodiment, as in the case of the first optical lens, the optical effect part which acts on outgoing beams is provided on the light exit surface side. These first through third optical lenses 5 through 7 can be prepared by means of a drawing machining.

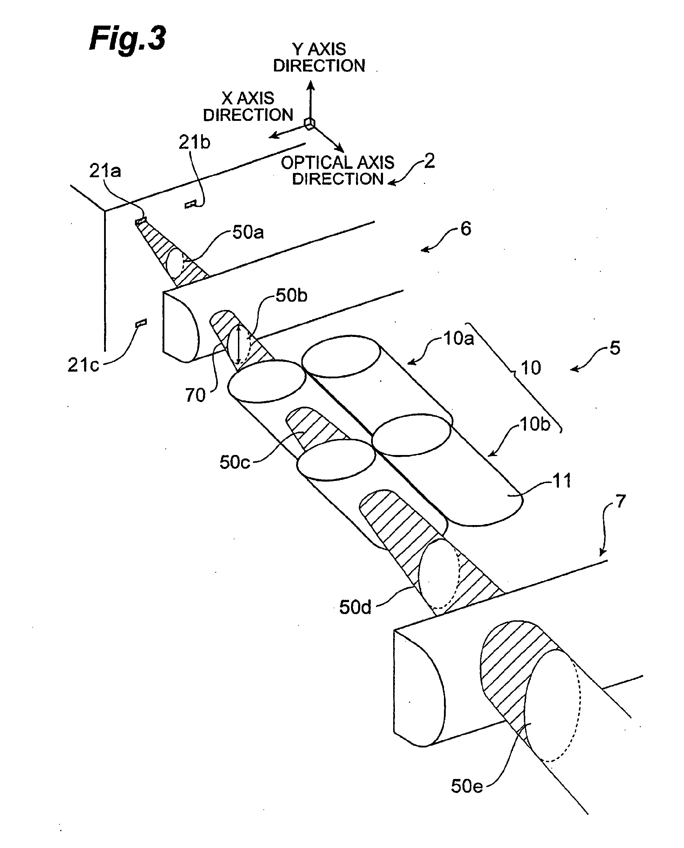

Fig. 3 is a drawing showing actions of the first through third optical lenses on beams emitted from the respective light emitting parts of the stack-type semiconductor laser element. For simplification of description, in the second optical lens 5, the optical member 12 in which lens arrays are embedded is not shown. The beam form and beam sectional shape, etc., shown in Fig. 3 may be expressed differently from the actual form and shape, however, they should be understood based on the technical description given below.

A beam emitted by the light emitting part 21a is a divergent beam, and has a beam section 50a having an oval shape that is long in the Y axis direction. Namely, the angle of divergence of the outgoing beam from the light emitting part 21 has a great vertical component (Y axial component) (50 to 60 degrees) and a small parallel component (X axial component) (up to 10 degrees). This beam is collimated first in the Y axis direction by the optical effect part formed on the light exit side of the first optical lens 6, whereby a beam section 50b is obtained. At this point, the outgoing beam outputted from the first optical lens 6 diverges in the X axis direction although it does not diverge in the Y axis direction since it has been collimated in the Y axis direction.

Next, the outgoing beam outputted from the first optical lens 6 is outputted after the axis of the beam section is rotated by 90 degrees by two tilt columnar lenses 10a and 10b. Namely, the outgoing beam outputted by the first optical lens 6, that is, the beam that has diverged in the Y axis direction and collimated in the X axis direction is outputted after being converted into a beam that has diverged in the Y axis direction and collimated in the X axis direction. The beam section changes from the beam section 50b to a beam section 50d due to actions of the cylindrical lenses 10a and 10b forming the second optical lens 5. The outgoing light from the second optical lens 5 is further collimated in the Y axis direction by the third optical lens 7, and as a result, an outgoing beam that has been collimated in both X axis direction and Y axis direction and has a beam section 50e is obtained.

In the stack-type semiconductor laser element 2, a plurality of light emitting parts which emit light to receive the actions as mentioned above by the optical lenses 5 through 7 are aligned in close formation in the X axis direction (in actuality, also stacked in the Y axis direction to form Y axial alignment, however, X axial alignment is first focused and described) . Particularly, in a case where the semiconductor laser device 1 is used as a laser device for laser machining, it is desirable that the number of light emitting parts is increased so as to obtain a higher output) . Furthermore, when constructing a light condensing lens for finally condensing these beams, it is better that the stack-type semiconductor laser element 2 is designed so that the entire X axial length becomes shorter.

In view of these circumstances, when the X axial pitch P₁ is set to be short, there is a possibility that the beams outputted by the light emitting parts 21a and 21b overlap each other in the X axis direction at a point comparatively close to the light emitting parts 21, however, in the semiconductor laser device of this embodiment, the beams are collimated in the Y axis direction by the first optical lens 6 and further rotated by 90 degrees by the second optical lens 5, and beams that have been collimated in the X axis direction are outputted, whereby overlapping of the beams in the X axis direction is eliminated.

However, in the stack-type semiconductor laser element 2, there is also the possibility that beams overlap each other in the Y axis direction since the light emitting parts 21 are also aligned in the Y axis direction. In the semiconductor laser device 1 of this embodiment, in order to prevent the beams from overlapping in the Y axis direction as a result of 90-degree rotation, the X axial pitch P₁ is designed to be larger than Y axial pitch P₂. Thereby, even when the second optical lens 5 is disposed at a position at which the outgoing beams from the first optical lens 6 diverge until the X axial component length thereof becomes equal to P₁ (that is, at a position at which the beams start overlapping each other in the X axis direction) , the beams are within they axial pitch P₂ by being rotated by 90 degrees, so that they are prevented from overlapping each other in the Y axis direction. At the same time, it also becomes possible to separate the position of the third optical lens 7 from the light emitting parts 21.

As for the Y axis direction, it is better that the Y axial pitch P₂ is set to be small so that the Y axial length of the entire stack-type semiconductor laser element 2 becomes short (for the same reason as in the case of P₁), however, as mentioned above, the form of the light emitting part is long in the X axis direction and short in the Y axis direction, so that the Y axial length of the entire stack-type semiconductor laser element 2 can be designed to be smaller accordingly. In the stack-type semiconductor laser element 2, heat sinks as heat radiation members may be alternately interposed between the array-type semiconductor laser elements 3 of each stack, and related to such a reason for designing the device to be long in the Y axis direction, it is efficient that the stack-type semiconductor laser element 2 is designed by providing certain spaces in the Y axis direction.

Furthermore, in the semiconductor laser device 1 of this embodiment, the first optical lens 6 is disposed so that the Y axial component length 70 of an outgoing beam from this lens becomes shorter than P₁. Thereby, even after beams are rotated by 90 degrees by the second optical lens 5, they are within the X axial pitch P₁, so that they are prevented from overlapping each other in the X axis direction.

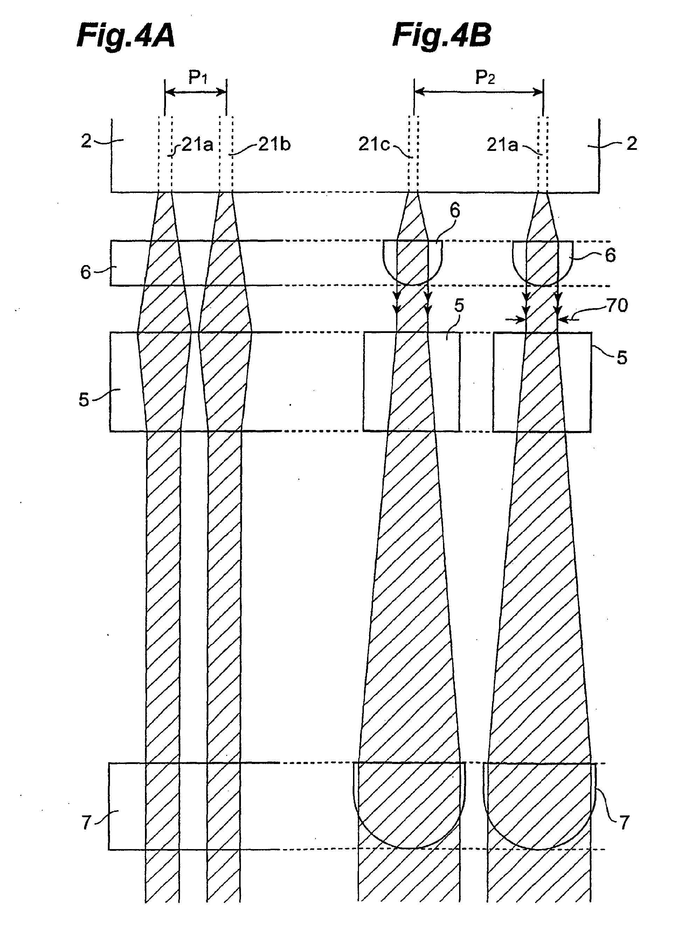

Fig. 4A and Fig. 4B show the paths of beams emitted from two adjacent light emitting parts. Fig. 4A is a sectional plan view of the semiconductor laser device 1 of this embodiment, wherein the paths of beams emitted from light emitting parts 21a and 21b that are adjacent to each other in the X axis direction are shown. As clearly seen in Fig. 4A, beams emitted from the respective light emitting parts 21a and 21b diverge up to a point immediately before they overlap each other in the X axis direction before the second optical lens 5 (that is, diverge until the X axial component length reaches P₁) , however, they are rotated by 90 degrees around the optical axes by the second optical lens 5 and exchanged into components that have been collimated by the first optical lens 6, and this prevents the beams from overlapping in the X axis direction.

Furthermore, rotation by 90 degrees around the optical axes by the second optical lens 5 results in an exchange in the Y axis direction into components that have diverged until the X axial component length reaches P₁. However, in this embodiment, designing is carried out so as to satisfy P₁ (= 500µm) < P₂ (= 1500µm) , so that beams are prevented from overlapping. As shown in Fig. 4B, the position of overlapping the respective outgoing beams of the second optical lens 5 is moved ahead, so that it becomes possible to move ahead the position of arrangement of the third optical lens 7 which collimates the beams in the X axis direction. In actual designing, thicknesses of the optical lenses 5 through 7 and possible actions within the thicknesses are also considered.

In a case where the second optical lens 5 is not installed and beams are not rotated by 90 degrees, it is conventionally required to install, in Fig. 4B, an optical lens which collimates beams emitted from the light emitting parts 21a and 21c in the Y axis direction before the position at which the beams overlap each other, however, in comparison with this, the restriction on arrangement is greatly eased in the semiconductor laser device 1 of this embodiment. In order to easily understand this effect, Fig. 4B describes a case where the third optical lens 7 is made furthest from the light emitting part 21.

When P₁ < P₂ is not satisfied, in order to prevent beams emitted from the light emitting parts 21a and 21b from overlapping in the Y axis direction as a result of rotation by 90 degrees, it is necessary to provide a second optical lens 5 at a position at which the X axial component length of the beams emitted from the light emitting parts 21a and 21b is smaller than P₂ (≤ P₁). On the other hand, in the semiconductor laser device 1 of this embodiment, the second optical lens is positioned at any position before the position at which the X axial component length of the beams emitted from the light emitting parts 21a and 21b reaches P₁, and this also shows that the restriction on arrangement is eased.

Furthermore, beams emitted from the light emitting parts 21a and 21c are collimated in the Y axis direction by the first optical lens 6, however, since the first optical lens 6 is disposed so that the Y axial component length 70 of outgoing beams from the first optical lens 6 does not exceed P₁ as shown in Fig. 4B, even after the beams are rotated by 90 degrees by the second optical lens 5, the outgoing beams are prevented from overlapping in the X axis direction as shown in Fig. 4A.

The invention has been described in detail as in the above, and is not limited to the abovementioned embodiment to carry out the invention, and includes all modifications and variations without departing from the scope of the following claims of the invention, wherein shapes, sizes, arrangements, and construction are changeable.

### INDUSTRIAL APPLICABILITY

The invention makes possible a semiconductor laser device in which the restriction on arrangement of optical lenses that act on beams emitted from light emitting parts is reduced.

Furthermore, the invention can provide a semiconductor laser device which can move ahead the position of overlapping of beams emitted from a stack-type semiconductor laser element by applying an optical path converter which rotates the beams around the optical axes.

## Claims

1. A semiconductor laser device comprising:
a stack-type semiconductor laser element, formed by piling up a plurality of stacks of array-type semiconductor laser elements, including apluralityof light emittingparts aligned in an X axis direction, along a Y axis direction crossing the X axis direction, where the optical axes of beams emitted from the plurality of light emitting parts are orthogonal to the X axis direction and the Y axis direction, and the X axial pitch P₁ of the light emitting parts and the Y axial pitch P₂ of the light emitting parts satisfy a relational expression of P₁ < P₂;
a first optical lens which acts on beams emitted from the light emitting parts of the stack-type semiconductor laser element in the Y axis direction; and
a second optical lens which outputs the beams outputted from the first optical lens after rotating them around the optical axes.

2. The semiconductor laser device according to Claim 1, wherein the second optical lens outputs beams that have been outputted from the light emitting parts of the stack-type semiconductor laser element after rotating them by 90 degrees around the optical axes.

3. The semiconductor laser device according to Claim 1 or 2, wherein the first optical lens is disposed at aposition before beams emitted from the light emitting parts of the stack-type semiconductor laser element overlap each other in the Y axis direction.

4. The semiconductor laser device according to any one of Claims 1 through 3, wherein the first optical lens is positioned at which the Y axial component length of outgoing beams obtained as a result of action of the stack-type semiconductor laser device on the beams emitted from the light emitting parts becomes smaller than the X axial pitch P₁ of the light emitting parts.

5. The semiconductor laser device according to any one of Claims 1 through 4, further comprising a third optical lens which acts on beams outputted from the second optical lens in the Y axis direction.

6. The semiconductor laser device according to any one of Claims 1 through 5, wherein heat sinks are interposed between the array-type semiconductor laser elements in the stack-type semiconductor laser element.
